# EUROPEAN PATENT SPECIFICATION

(11) **EP 0 645 816 B1**
(45) Date of publication and mention of the grant of the patent: **28.10.1998**
(21) Application number: 94307152.2
(22) Date of filing: 29.09.1994
(51) Int. Cl.: H01L 25/065, H01L 23/48, H01L 25/07

(54) **Semiconductor device comprising a plurality of semiconductor elements**
Halbleiteranordnung mit einer Mehrzahl von Halbleiterelementen
Dispositif semi-conducteur comprenant une pluralité d'éléments semi-conducteurs

(30) Priority: 29.09.1993 JP 242266/93
(43) Date of publication of application: 29.03.1995
(73) Proprietor: FUJI ELECTRIC CO. LTD., Kawasaki 210 (JP)
(72) Inventor: Takahashi, Yoshikazu, Kawasaki-ku, Kawasaki 210 (JP)
(74) Representative: Bridge-Butler, Alan James

(56) References cited:
- EP-A- 0 108 646
- GB-A- 2 189 343
- US-A- 4 893 172

## Description

The present invention relates to a semiconductor device comprising a plurality of semiconductor elements such as insulated-gate bipolar transistors (IGBTs) received in one container and also to a method of fabricating the semiconductor device.

Receiving plural semiconductor elements of one or more kinds in one container and modularising them have found wide acceptance because the capacity is increased and because the labour needed to make wire connections can be reduced. For example, what is presently known as an IGBT module comprises one container in which plural IGBT chips and a flywheel diode chip are received. Numerous aluminium bonding wires are brought out from main electrodes (such as emitter and cathode electrodes on the top surfaces of the element chips) and from control electrodes (such as gate electrodes) to make connections. Accordingly, in this IGBT module, cooling is done only from the collector side on the bottom of each chip.

As described above, connections of the emitters of the IGBT module depends on the aluminium wire bonding having a diameter of about 300 µm. Therefore, heat dissipation from the collector side is possible but heat dissipation from the emitter side can be hardly expected. Consequently, the current capacity is limited.

In recent years, more compact IGBT modules having greater capacity than conventional modules have been required in industrial and vehicular applications. As the capacity of a module is increased, more IGBT chips must be integrated in the module. Hence, it is inevitable that the module itself is increased in size. Also, the number of aluminium wires bonded inside the module is inevitably increased and may reach several tens or several hundreds. Therefore, the reliability in the presence of vibrations presents great problems. In addition, the aluminium wires, and the terminals to which the aluminium wires are connected, are lengthened. As a result, their inductances increase. When a large current is turned off, the resulting voltage surge increases. This is disadvantageous in the design of an apparatus. On the other hand, in one conceivable method, wire bonding is not used for emitter connections, but instead top emitter electrodes are in contact with an emitter terminal board in a plane as used in a flat type semiconductor device such as a GTO thyristor. However, where plural IGBT chips and a flywheel diode are connected in parallel and brought into contact with each other under pressure by a common terminal board, if the distance between the bottom surface of the common terminal board and each electrode on the top surface of each chip is not uniform before the application of the pressure, then it is not possible to apply uniform pressure to the whole module. In consequence, uniform energisation cannot be made. It is an object of the present invention to provide a semiconductor device which comprises a plurality of semiconductor elements received in a container and in which terminal boards can be brought into contact with electrodes lying on one main surface of each semiconductor element by applying uniform pressure. Also, it is an object of the invention to provide a method of fabricating this semiconductor device.

GB-A-2 189 343 describes a semiconductor element module having a housing which may contain a plurality of semiconductor elements connected to external terminals. The distance between the terminals is adjustable. The terminals are preferably connected to the semiconductor elements by a compression assembly in which the pressure is applied using a spring such as a plate spring.

According to claim 1 of the present invention there is provided a semiconductor device.

There is also provided a method of fabricating a semiconductor device according to claim 3.

Preferably the contour of the intermediate terminal boards is made to conform to the contour of the semiconductor elements and the intermediate terminal boards are placed in position relative to the semiconductor elements using a cylindrical jig.

The intermediate terminal boards whose heights can be adjusted according to the heights of the electrode surfaces of the semiconductor elements are inserted between the top terminal board and the electrode surfaces of the semiconductor elements. Thus, variations in the thickness of the semiconductor elements or variations in the thickness of brazes or solders are absorbed so that the top surfaces of the intermediate terminal boards are made equal to each other. Pressure applied from the outside to the top terminal board is uniformly applied to the interfaces between the electrode surfaces of the semiconductor elements and the surfaces of the intermediate terminals. Means for dissipating the heat from the semiconductor elements is not limited to the bottom terminal board as in the prior art techniques. Rather, heat is also dissipated from the top terminal board and so uniform heat dissipation takes place. Consequently, the cooling efficiency increases dramatically. The heights of the intermediate terminal boards can be easily adjusted by polishing the protrusions on the intermediate terminal boards. The intermediate terminal boards and the semiconductor elements can be easily placed in position relative to each other by the use of the cylindrical jig by making the contour of the intermediate terminal boards conform to the contour of the semiconductor elements.

Embodiments of the invention will now be described in detail with reference to the drawings, in which:
Figure 1, (a)-(i), are cross-sectional views illustrating successive steps of a method of fabricating an IGBT module according to the invention;
Figure 2 is a plan view of the IGBT module fabricated by the steps of Figure 1, excluding the upper structure;
Figure 3 is a side elevation of an intermediate terminal board for IGBT, the board being used in the manufacturing method illustrated in Figure 1; and
Figure 4 is a side elevation of an intermediate terminal board for a diode, the board being used in the manufacturing method illustrated in Figure 1.

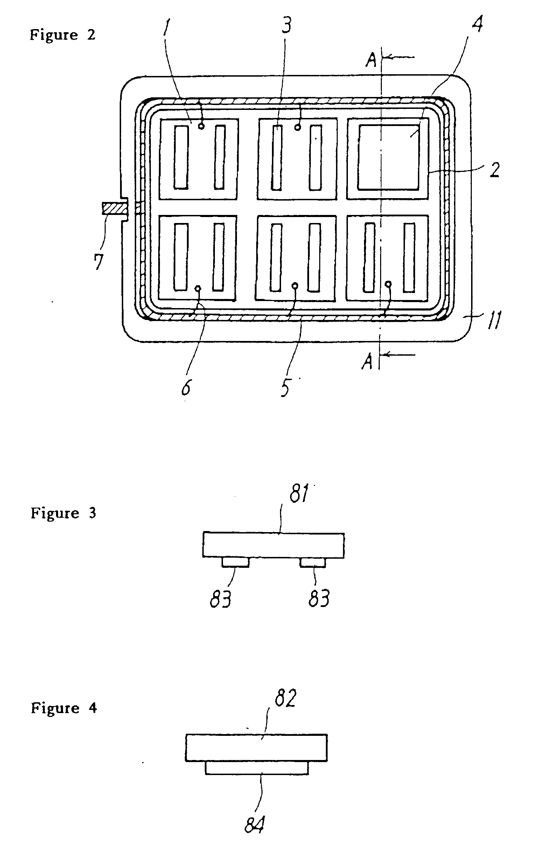

Figure 2 is a plan view of the lower structure of an IGBT module forming one example of the present invention. A container has a ceramic side wall 11 inside of which 5 IGBT chips 1 and one flywheel diode chip 2 are accommodated. Two emitter electrodes 3 are formed on the top surface of each IGBT chip 1. A cathode electrode 4 is formed on the top surface of the diode chip 2. A gate interconnect 5 is laid outside the chips and connected with gate pads of the IGBT chips by aluminium bonding wires 6. The gate interconnect is brought out by a gate lead 7 extending through the side wall of the container.

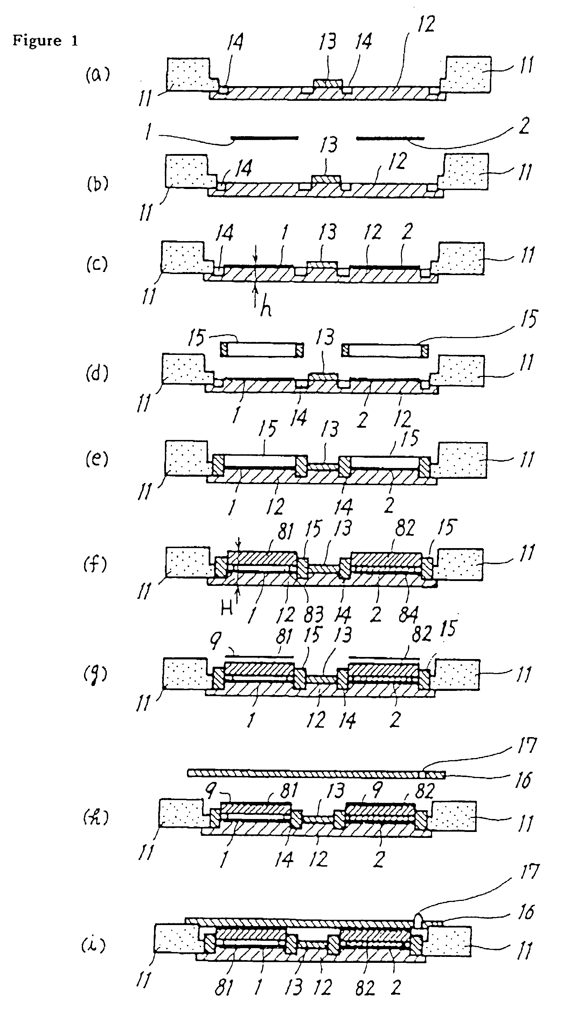

Figure 1, (a)-(i), show steps for assembling the upper structure of this IGBT module. These figures are cross sections taken in the plane A-A of the plan view of Figure 2. First, a conductive bottom terminal board 12 is brazed to the ceramic container side wall 11, a spacer 13 being firmly secured to the centre of the terminal board 12 (Figure 1(a)). The bottom terminal board 12 is provided with a groove 14 in which a positioning jig is inserted. Then, the IGBT chip 1 is brazed or soldered to the region surrounded by the groove 14 in the bottom terminal board 12, for example by a high-temperature solder, such that the collector electrodes of the IGBT chips 1 and the anode electrode of the diode chip 2 face downward (Figure 1(b)). At this time, the difference in thickness between each IGBT chip 1 and the diode chip 2 is about 200 µm. Also, variations in thickness of the IGBT chips 1 are about ± 15 µm. Furthermore, the thickness of the high-temperature solder layer varies by about ± 30 µm. Accordingly, the height h (Figure 1(c)) of the top surface of each chip from the bottom surface of the terminal board 12 is measured at a resolution of about 0.5 µm by making use of an accurate measuring instrument such as a laser rangefinder. Subsequently, a positioning cylindrical jig 15 is prepared (Figure 1(d)). This is inserted into the groove 14 in the bottom terminal board 12, followed by bonding of the gate wires 6 shown in the IGBT plan view of Figure 2 (Figure 1(e)). Then, intermediate terminal boards 81 and 82 are inserted into the jig 15 (Figure 1(f)). The intermediate terminal board 81 for the IGBT chips 1 is provided with belt-like protruding portions 83 whose shape corresponds to the two-dimensional shape of the emitter electrodes 3 as shown in Figure 3. The intermediate terminal board 82 for the diode chip 2 is provided with a protruding portion 84 in the form of a square, the shape of the protruding portion 84 corresponding to the two-dimensional shape of the cathode electrode 4 as shown in Figure 4. Based on previously measured data about the height h shown in Figure 1(c), processing is performed by a personal computer or the like. The top surface or surfaces of the protruding portions 83 or protruding portions 84 are accurately polished at an accuracy of the order of 1 µm with a grinding stone so that the heights h from the bottom surface of the bottom terminal board 12 to the top surface of the intermediate terminal board 81 or 82 become uniform. After inserting the intermediate terminal boards 81 and 82, the heights H are checked. To secure safety, a buffer plate 9 (Figure 1(g)) having a thickness of about 100 µm and consisting of oxygen-free copper or the like is placed to absorb variations in the height H still remaining on the intermediate terminal boards 81 and 82. After hermetically coupling a common top terminal board 16 to the side wall of the container, nitrogen, helium, or the like is injected through a vent hole 17, and the container is sealed off (Figure 1, (h), (i)).

According to the present invention, variations in height of the top electrode surfaces of plural semiconductor elements, due to different thicknesses and other variations in the semiconductor elements, are cancelled out by the heights of intermediate terminal boards inserted between the electrode surfaces and the top terminal board. Pressure applied from the outside via the top terminal board brings the semiconductor elements into uniform contact with the top terminal board under even pressure, so that they are interconnected. In this way, both top and bottom surfaces of each of the plural semiconductor elements contained in one container can be cooled. In consequence, the current capacity increases, and the inductance decreases.

## Claims

1. A semiconductor device characterised in that it comprises:
a container having an insulating side wall (11) and top and bottom conductive terminal boards (16,12) having their outer peripheral portions coupled to top and bottom ends of the side wall (11);
a plurality of semiconductor elements (1,2) contained in the container having electrodes (3,4) on their top surfaces and electrodes on their bottom surfaces;
the electrodes on the bottom surfaces of the semiconductor elements (1,2) being rigidly fixed to the bottom terminal board (12); and
the top terminal board (16) disposed opposite to the electrodes (3,4) on the top surfaces with intermediate terminal boards (81,82) interposed therebetween, said intermediate terminal boards having individually height adjusted contact elements (83,84), each making contact to respective electrodes (3,4) on the top surfaces of the semiconductor elements.

2. A semiconductor device according to claim 1,
characterised in that each of the intermediate terminal boards (81,82) comprises a flat portion of a given thickness and protruding portions (83,84) forming said contact elements, said protruding portions having a surface capable of making contact with the electrode surfaces (3,4) on the top surfaces of the semiconductor elements (1,2).

3. A method of fabricating a semiconductor device characterised in that it comprises the steps of:
coupling an insulating side wall (11) of a container to an outer peripheral portion of a conductive bottom terminal board (12);
rigidly securing electrodes formed on the respective bottom surfaces of a plurality of semiconductor elements (1,2) to the inner surface of the conductive bottom terminal board (12);
measuring the heights of the top surface of electrodes (3,4) formed on the top surfaces (3,4) of the secured semiconductor elements (1,2) from the outer surface of the bottom terminal board (12);
providing one intermediate terminal board (81,82) for each semiconductor element, said intermediate terminal boards having on their bottom surface protrudering portions (83,84) forming contact elements;
polishing the heights of the protruding portions (83,84) of the intermediate terminal boards (81,82) so that when the intermediate terminal boards are placed on the respective semiconductor elements the heights from the outer surface of the bottom terminal board to the top surface of said intermediate terminal boards is uniform;
placing the intermediate terminal boards (81,82) having the polished protruding portions (83,84) on the respective electrodes formed on the top surfaces of the semiconductor elements (1,2); and
coupling the insulating side wall (11) to the outer peripheral portion of a conductive top terminal board (16).

4. A method of fabricating a semiconductor device according to claim 3, characterised in that the intermediate terminal boards (81,82) are made to correspond in contour to the semiconductor elements (1,2), and the intermediate terminal boards (81,82) are placed in a position relative to the semiconductor elements (1,2) and placed on the semiconductor elements (1,2) using a jig (15).

5. A method of fabricating a semiconductor device according to claim 4, characterised in that the jig (15) is located relative to the device by engaging the bottom terminal board (12).

6. A method of fabricating a semiconductor device according to claim 5, characterised in that the bottom terminal board (12) is formed with a recess 14 into which a cooperating element of the jig (15) engages.

## Patentansprüche

1. Halbleiteranordnung **dadurch gekennzeichnet**, daß sie umfaßt:
einen Container, welcher eine isolierende Seitenwand 11 und obere und untere leitfähige Terminalboards (16, 12) besitzt, welche mit ihren äußeren peripheren Abschnitten an oberen und unteren Enden der Seitenwand (11) angekoppelt sind;
eine Mehrzahl von Halbleiterelementen (1, 2), welche in dem Container enthalten sind, wobei sie Elektroden (3, 4) auf ihren oberen Oberflächen und Elektroden an ihren unteren Oberflächen besitzen;
wobei die Elektroden auf den unteren Oberflächen der Halbleiterelemente (1, 2) fest mit dem Boden-Terminalboard (12) verbunden sind; und
das Deck-Terminalboard (16) gegenüber den Elektroden (3, 4) auf den oberen Oberflächen mit dazwischengesetzten Zwischen-Terminalboards (81, 82) angeordnet wird, wobei die besagten Zwischen-Terminalboards individuell höhenangepaßte Kontaktelemente (83, 84) besitzen, welche jeweils Kontakt zu entsprechenden Elektroden (3, 4) auf den oberen Oberflächen der Halbleiterelemente herstellen.

2. Halbleiteranordnung nach Anspruch 1, **dadurch gekennzeichnet**, daß jedes der Zwischen-Terminalboards (81, 82) einen flachen Abschnitt einer gegebenen Dicke und überstehende Abschnitte (83, 84) besitzt, welche die besagten Kontaktelemente bilden, wobei die besagten überstehenden Abschnitte eine Oberfläche besitzen, welche den Kontakt mit den Elektrodenoberflächen (3, 4) auf den oberen Oberflächen der Halbleiterelemente (1, 2) herstellen kann.

3. Eine Methode zur Herstellung einer Halbleiteranordnung, **dadurch gekennzeichnet**, daß sie umfaßt die Schritte:
Koppeln einer isolierenden Seitenwand (11) eines Containers an einen äußeren peripheren Abschnitt eines leitfähigen Boden-Terminalboards (12);
festes Sichern von Elektroden, welche auf den jeweiligen unteren Oberflächen einer Mehrzahl von Halbleiterelementen (1, 2) gebildet sind, an der inneren Oberfläche des leitfähigen Boden-Terminalboards (12);
Messen der Höhen der oberen Oberfläche der auf den oberen Oberflächen (3, 4) gebildeten Elektroden der gesicherten Halbleiterelemente (1, 2) von der äußeren Oberfläche des Boden-Terminalboards (12);
Vorsehen eines Zwischen-Terminalboards (81, 82) fiir jedes Halbleiterelement, wobei die besagten Zwischen-Terminalboards an ihrer unteren Oberfläche überstehende Abschnitte (83, 84) besitzen, welche Kontaktelemente bilden;
Polieren der Höhen der überstehenden Abschnitte (83, 84) der Zwischen-Terminalboards (81, 82), so daß die Höhen von der äußeren Oberfläche des Boden-Terminalboards bis zur oberen Oberfläche der besagten Zwischen-Terminalboards gleichmäßig sind, wenn die Zwischen-Terminalboards auf die jeweiligen Halbleiterelemente gesetzt werden;
Plazieren der Zwischen-Terminalboards (81, 82) mit den polierten überstehenden Abschnitten (83, 84) auf den entsprechenden Elektroden, welche auf den oberen Oberflächen der Halbleiterelemente (1, 2) gebildet sind; und
Koppeln der isolierenden Seitenwand (11) an den äußeren peripheren Abschnitt eines leitenden Deck-Terminalboards (16).

4. Eine Methode zur Herstellung einer Halbleiteranordnung nach Anspruch 3, **dadurch gekennzeichnet**, daß die Zwischen-Terminalboards (81, 82) in der Kontur zum Korrespondieren mit den Halbleiterelementen (1, 2) gebracht werden, und die Zwischen-Terminalboards (81, 82) in eine Position relativ zu den Halbleiterelementen (1, 2) plaziert werden und unter Nutzung einer Lehre (15) auf den Halbleiterelementen (1, 2) plaziert werden.

5. Methode zur Herstellung einer Halbleiteranordnung nach Anspruch 4, **dadurch gekennzeichnet**, daß die Lehre (15) durch Eingriff mit dem Boden-Terminalboard (12) relativ zu der Anordnung lokalisiert ist.

6. Methode zur Herstellung einer Halbleiteranordnung nach Anspruch 5, **dadurch gekennzeichnet**, daß das Boden-Terminalboard (12) mit einer Aussparung (14) ausgebildet ist, in welche ein kooperierendes Element der Lehre (15) eingreift.

## Revendications

1. Dispositif à semi-conducteurs caractérisé en ce qu'il comporte :
un conteneur ayant une paroi latérale isolante (11) et des plaquettes à bornes conductrices supérieure et inférieure (16, 12) ayant leurs parties périphériques extérieures reliées aux extrémités supérieure et inférieure de la paroi latérale (11),
une pluralité d'éléments semi-conducteurs (1, 2) contenus dans le conteneur ayant des électrodes (3, 4) sur leurs surfaces supérieures et des électrodes sur leurs surfaces inférieures,
les électrodes situées sur les surfaces inférieures des éléments semi-conducteurs (1, 2) étant fixées de manière rigide à la plaquette à bornes inférieure (12),
la plaquette à bornes supérieure (16) étant disposée en face des électrodes (3, 4) situées sur les surfaces supérieures, des plaquettes à bornes intermédiaires (81, 82) étant interposées entre celles-ci, lesdites plaquettes à bornes intermédiaires ayant des éléments de contact (83, 84) individuellement ajustés en hauteur, chacun établissant un contact avec des électrodes respectives (3, 4) situées sur les surfaces supérieures des éléments semi-conducteurs.

2. Dispositif à semi-conducteurs selon la revendication 1, caractérisé en ce que chacune des plaquettes à bornes intermédiaires (81, 82) comporte une partie plate ayant une épaisseur donnée et des parties en saillie (83, 84) formant lesdits éléments de contact, lesdites parties en saillie ayant une surface capable d'établir un contact avec les surfaces d'électrode (3, 4) situées sur les surfaces supérieures des éléments semi-conducteurs (1, 2).

3. Procédé de fabrication d'un dispositif à semi-conducteurs caractérisé en ce qu'il comporte les étapes consistant à :
relier une paroi latérale isolante (11) d'un conteneur à une partie périphérique extérieure d'une plaquette à bornes inférieure conductrice (12),
fixer de manière rigide les électrodes formées sur les surfaces inférieures respectives d'une pluralité d'éléments semi-conducteurs (1, 2) à la surface intérieure de la plaquette à bornes inférieure conductrice (12),
mesurer les hauteurs de la surface supérieure des électrodes (3, 4) formées sur les surfaces supérieures des éléments semi-conducteurs fixés (1, 2) à partir de la surface extérieure de la plaquette à bornes inférieure (12),
agencer une plaquette à bornes intermédiaire (81, 82) pour chaque élément semi-conducteur, lesdites plaquettes à bornes intermédiaires ayant, sur leur surface inférieure, des parties en saillie (83, 84) formant des éléments de contact,
polir les hauteurs des parties en saillie (83, 84) des plaquettes à bornes intermédiaires (81, 82) de sorte que, lorsque les plaquettes à bornes intermédiaires sont placées sur les éléments semi-conducteurs respectifs, les hauteurs, allant de la surface extérieure de la plaquette à bornes inférieure à la surface supérieure desdites plaquettes à bornes intermédiaires, sont uniformes,
placer les plaquettes à bornes intermédiaires (81, 82) ayant les parties en saillie polies (83, 84) sur les électrodes respectives formées sur les surfaces supérieures des éléments semi-conducteurs (1, 2), et
relier la paroi latérale isolante (11) à la partie périphérique extérieure d'une plaquette à bornes supérieure conductrice (16).

4. Procédé de fabrication d'un dispositif à semi-conducteurs selon la revendication 3, caractérisé en ce que les plaquettes à bornes intermédiaires (81, 82) sont fabriquées pour correspondre au profil des éléments semi-conducteurs (1, 2), et les plaquettes à bornes intermédiaires (81, 82) sont placées dans une position par rapport aux éléments semi-conducteurs (1, 2), et placées sur les éléments semi-conducteurs (1, 2) en utilisant une monture (15).

5. Procédé de fabrication d'un dispositif à semi-conducteurs selon la revendication 4, caractérisé en ce que la monture (15) est positionnée par rapport au dispositif en venant en prise avec la plaquette à bornes inférieure (12).

6. Procédé de fabrication d'un dispositif à semi-conducteurs selon la revendication 5, caractérisé en ce que la plaquette à bornes inférieure (12) est munie d'un creux (14) dans lequel vient en prise un élément de coopération de la monture (15).
